# EUROPÄISCHE PATENTSCHRIFT

(11) **EP 0 938 009 B1**
(45) Veröffentlichungstag und Bekanntmachung des Hinweises auf die Patenterteilung: **27.07.2005**
(21) Anmeldenummer: 99100845.9
(22) Anmeldetag: 19.01.1999
(51) Int. Cl.: G02B 7/00, G03F 7/20

(54) **Optische Anordnung und Projektionsbelichtungsanlage der Mikrolithographie mit passiver thermischer Kompensation**
Optical device and a microlithography projection exposure system with passive thermal compensation
Dispositif optique et appareil d'exposition par projection pour microlithographie avec compensation thermique passive

(30) Priorität: 20.02.1998 DE 19807094
(43) Veröffentlichungstag der Anmeldung: 25.08.1999
(73) Patentinhaber: Carl Zeiss SMT AG, 73446 Oberkochen (DE)
(72) Erfinder: Wagner, Christian Dr., 73431 Aalen (DE); Trunz, Michael, 73479 Ellwangen (DE); Hilgers, Ralf, 73434 Aalen (DE)
(74) Vertreter: Müller-Rissmann, Werner Albrecht, Dr.

(56) Entgegenhaltungen:
- EP-A- 0 678 768
- EP-A- 0 853 357
- US-A- 4 155 631
- PATENT ABSTRACTS OF JAPAN vol. 011, no. 037 (P-543), 4. Februar 1987 & JP 61 208002 A (TOSHIBA CORP), 16. September 1986
- PATENT ABSTRACTS OF JAPAN vol. 008, no. 285 (E-287), 26. Dezember 1984 & JP 59 150488 A (TOSHIBA KK), 28. August 1984
- PATENT ABSTRACTS OF JAPAN vol. 018, no. 194 (P-1722), 5. April 1994 & JP 06 003510 A (PIONEER ELECTRON CORP), 14. Januar 1994
- PATENT ABSTRACTS OF JAPAN vol. 009, no. 031 (E-295), 9. Februar 1985 & JP 59 175178 A (MITSUBISHI DENKI KK), 3. Oktober 1984

## Beschreibung

Die Erfindung betrifft eine Projektionsbelichtungsanlage der Mikrolithographie mit einem optischen Element, das durch Strahlung nicht rotationssymmetrisch beheizt wird.

Diese Situation hat eine besondere Bedeutung bei Wafer-Scannern mit einem schlitzförmigen Bildfeld - entweder ein schmales Rechteck mit Verhältnis Breite zu Länge z.B. von typisch 1:5 bis zu 1:9, oder insbesondere bei Spiegelsystemen auch kreisbogenförmig.

Eine aktive Kompensation dadurch verursachter Abbildungsfehler ist aus EP-A 0 678 768 bekannt durch geregeltes oder gesteuertes nicht rotationssymmetrisches Heizen oder Kühlen oder andeutungsweise auch durch mechanisches Spannen.

Schon früher ist derartiges in der EP-B1 0 532 236 beschrieben, vorzugsweise als Heizung für Spiegel.

Aufgabe der Erfindung ist es, die durch Lichtabsorption und daraus folgende Erwärmung verursachte Veränderung der Eigenschaften optischer Elemente bei Projektionsbelichtungsanlagen mit möglichst einfachen Mitteln deutlich zu reduzieren bzw. zu symmetrisieren.

Gelöst wird diese Aufgabe durch eine Projektionsbelichtungsanlage nach Anspruch 1.

Auf aktive, gesteuerte oder geregelte Eingriffe an den optischen Elementen wird verzichtet. Durch die Vermeidung aktiver Elemente und besonders einer Heizung wird der gesamte Energieeintrag in die Anordnung reduziert.

Andererseits geht die Erfindung mit der asymmetrischen Kühlung von bewährten, und besonders bei Projektionsbelichtungsanlagen bisher auf die Spitze getriebenen, Bauprinzipien der Fassungen mit hoher Symmetrie ab.

Die Ansprüche 2 und 4 sehen dabei eine Kühlung durch Teile ohne Fassungsfunktion vor, so daß die eigentliche Fassung wieder symmetrisch bleiben kann.

Vorteilhafte Weiterbildungen der Erfindung sind Gegenstand der Unteransprüche 2 bis 18.

Näher erläutert wird die Erfindung anhand der Zeichnungen.
Figur 1 zeigt schematisch eine Linse mit schlitzförmiger Ausleuchtung und Laschenverbindungen der Fassung aus verschiedenen Materialien;
Figur 2 zeigt schematisch eine Linse mit dipolartiger Ausleuchtung und Verbindungen zur Fassung mit unterschiedlichen Querschnitten;
Figur 3a zeigt schematisch eine Linse mit schlitzförmiger Ausleuchtung in symmetrischer Fassung mit einem Kühlkörper von nicht rotationssymmetrischer Form;
Figur 3b zeigt einen Schnitt A-A von Figur 3a;
Figur 3c zeigt einen Schnitt B-B von Figur 3b;
Figur 4 zeigt schematisch im Querschnitt eine Variante mit Kühllasche und Wärmeleitkabel;
Figur 5a zeigt ein FEM-Modell mit symmetrisch angeordneten gleichen Kühlkörpern;
Figur 5b zeigt dazu schematisch einen Querschnitt;
Figur 6 zeigt ein gleichartiges FEM-Modell wie Figur 5a, bei dem die Kühlkörper nach Lage, Größe und Material variiert sind;
Figur 7 zeigt eine Variante mit einem Kühlkörper mit temperaturinduzierter Veränderung der Kühlwirkung;
Figur 8 zeigt im schematischen Schnitt einen Spiegel mit durch Stege aus verschiedenen Materialien bewirkter unterschiedlicher Kühlung; und
Figur 9 zeigt schematisch die Übersicht einer Projektionsbelichtungsanlage.

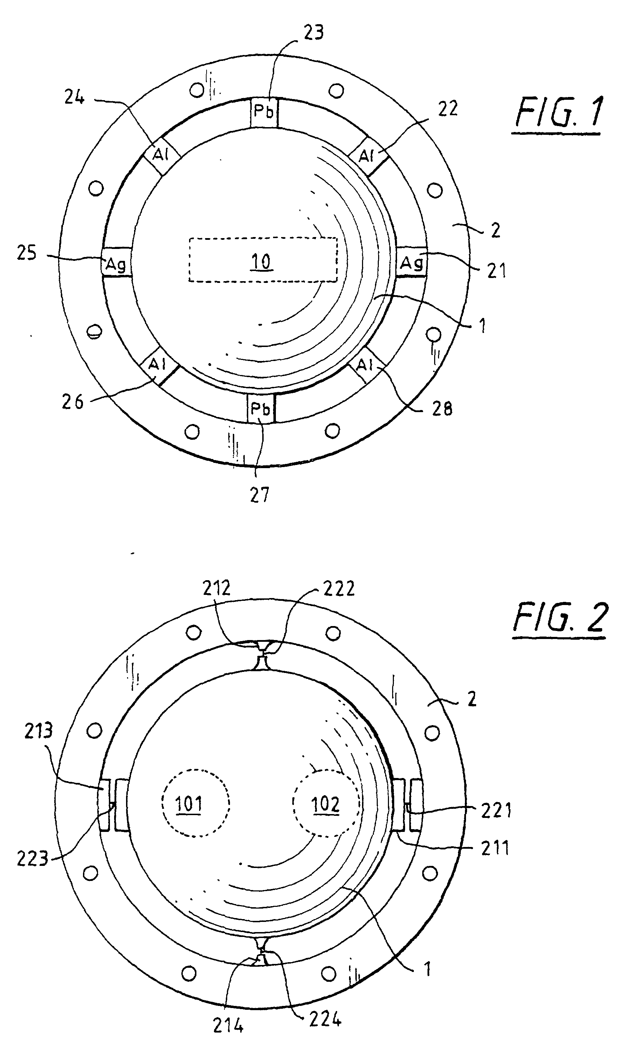

Die Anordnung der Figur 1 zeigt eine Linsenfassung 2, in der eine Linse 1 durch eine Vielzahl von Stegen 21-28 (gezeigt sind acht) weitestgehend spannungsfrei und exakt lagefixiert gehalten ist. Die Stege 21-28 (Speichen, Laschen) sind mit dem Rand der Linse 1 verklebt oder durch andere Fügeverfahren verbunden.

In einem schlitzförmigen Querschnitt 10 wird die Linse 1 ausgeleuchtet. Gerade bei Projektionsbelichtungsanlagen, die im UV- und DUV-Bereich arbeiten, ist das Problem, daß die Linsenwerkstoffe erhebliche Absorption aufweisen und in Folge also im Querschnitt 10 eine erhebliche Wärmezufuhr erfolgt. Die damit verbundene Temperaturerhöhung bewirkt eine Änderung des Brechungsindex und durch die Wärmeausdehnung zusätzlich eine Deformation. Insgesamt ergibt sich eine Veränderung der Linsenwirkung mit astigmatischer Wirkung.

Die Kühlung erfolgt nur zu einem geringen Teil über das Umgebungsgas (bei Projektionsbelichtungsanlagen in der Regel Helium) und durch Wärmestrahlung. Primär wird die Wärme über den Linsenkörper 1, die Fügestelle (Klebung) und das Gas in der Umgebung der Fügestelle und die Stege 21-28 auf die Fassung 2 abgeführt.

Erfindungsgemäß sind nun die Stege 21-28 in diesem Beispiel aus verschiedenen Materialien ausgeführt, womit sie unterschiedliche Wärmeleitfähigkeit aufweisen. Beispielsweise sind die dem schlitzförmigen Querschnitt 10 nächstgelegenen Stege 21, 25 aus Silber mit sehr guter Wärmeleitfähigkeit, die entferntesten 23, 27 aus Blei mit geringer Wärmeleitfähigkeit und die dazwischenliegenden Stege 22, 24, 26, 28 aus Aluminium mit mittlerer Wärmeleitfähigkeit. Die Temperaturverteilung in der Linse 1 wird also zwischen den Stegen 21, 23 relativ abgesenkt und zwischen den Stegen 23, 27 relativ angehoben, wodurch sich eine - zumindest teilweise - Homogenisierung und Symmetrisierung der Temperaturverteilung und eine reduzierte Störung der optischen Eigenschaften der Linse 1 ergibt.

In der Praxis sind auch weitere Eigenschaften der für die Stege 21-28 verwendeten Materialien, wie ihre Festigkeit, Elastizität, Wärmeausdehnung zu berücksichtigen. Simulationsrechnungen für die mechanischen, thermischen und optischen Eigenschaften unter Nutzung der Finite Elemente Methode ermöglichen hier eine optimierte Auswahl und Ausführung der Anordnung.

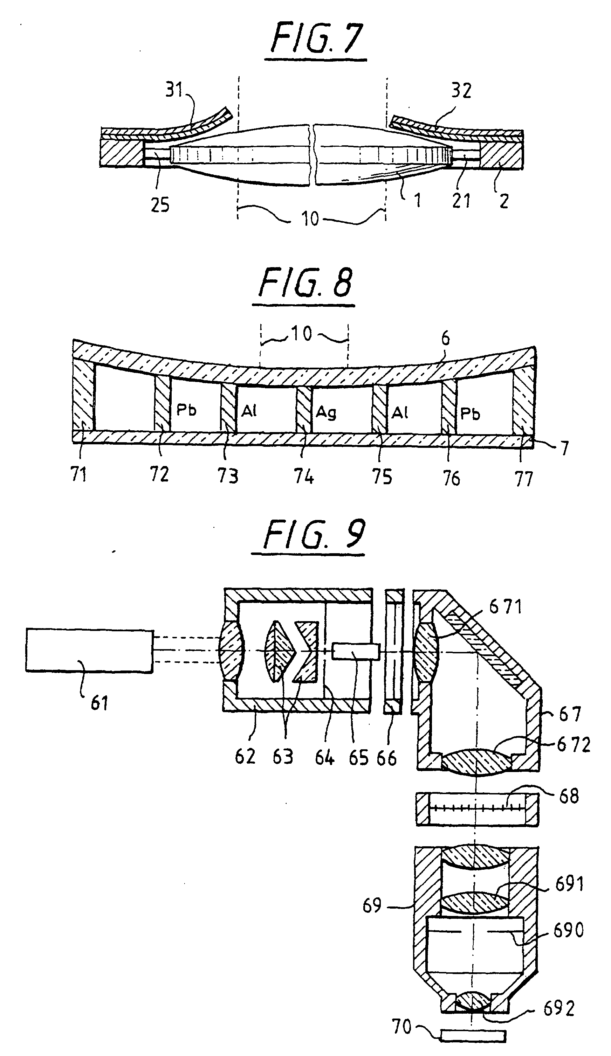

Eine Alternative, die sich aber auch zur Kombination mit oben genanntem Beispiel eignet, gibt Figur 2 wieder. Hier sind Linse 1 und Fassung 2 über Stege 211 bis 214 (vier Stück nur zur klaren Darstellung, in der Praxis mehr) mit unterschiedlichem Querschnitt und dadurch unterschiedlicher Wärmeleitung verbunden. Unterschiedliche mechanische Eigenschaften sind dadurch unterbunden, daß jeder Steg 211 bis 214 gleichartige Federgelenke 221 bis 224 aufweist. Die Wärmeleitung über die danebenliegenden schmalen Spalte (es werden nur minimale Beweglichkeiten der Gelenke benötigt) erfolgt hinreichend wirksam durch das Füllgas (Helium) oder durch ein parallel geschaltetes flexibles Metallkabel (Litze) (vgl. Fig. 6b).

Auch hier wird die genaue Kombination mit Unterstützung von Simulationsrechnungen festgelegt. Die Kombination mit der Verwendung unterschiedlicher Werkstoffe, wie in Figur 1 dargestellt, eröffnet erweiterte Anpassungsmöglichkeiten.

Weiter ist in dieser Figur 2 eine "Dipol"-Ausleuchtung der Linse mit zwei außermittigen Lichtflecken 101, 102 dargestellt, wie sie im Bereich der Blendenebene und äquivalenter Ebenen von Projektionsbelichtungssystemen mit symmetrischer schiefer Beleuchtung vorkommt. Auch damit ergeben sich astigmatische Fehler durch die Lichtabsorption, die durch die passivkompensierende Kühlung vermindert werden können.

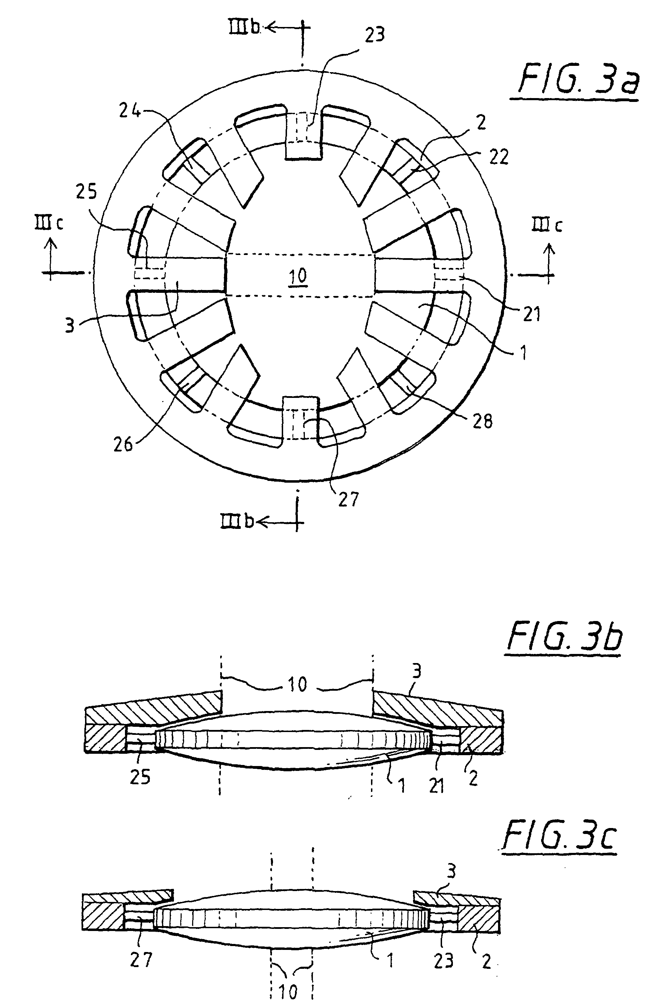

Figur 3a-c zeigt eine Variante der Erfindung mit einem zusätzlichen, nur für die ausgleichende Kühlung vorgesehenen, wärmeleitenden Element 3.

Linse 1 und Fassung 2 sind dabei beispielsweise mit gleichmäßigen Stegen oder mit selektiv kühlenden Stegen 21-28 nach Figur 1 oder 2 verbunden. Jede andere Fassungstechnik ist gleichermaßen.anwendbar.

Das wärmeleitende Element 3 ist mit der Fassung 2 gut wärmeleitend fest verbunden und überdeckt Teile der Linse 1, welche nicht vom Licht durchdrungen werden, also außerhalb der auch hier als Schlitz dargestellten ausgeleuchteten Fläche 10.

Diese Überdeckung erfolgt vorzugsweise berührungsfrei, etwa mit einem Abstand von rund 0,1 mm, so daß unter Vermittlung des Füllgases eine gute Wärmeübertragung gewährleistet ist, zugleich aber keine Spannungen in die Linse 1 eingetragen werden können. Bessere Wärmeleitung ergibt sich natürlich, wenn der Spalt zwischen Linse 1 und wärmeleitendem Element 3 mit Kleber, einem Gel, Flüssigkristallen oder ähnlichem, möglichst wenig Spannung übertragendem Material, ausgefüllt wird.

Die Wärmeleitung und deren lokale Verteilung wird durch die Form des wärmeleitenden Teils 3 eingestellt - Figur 3b zeigt, wie das Teil 3 bis nahe an den ausgeleuchteten Bereich 10 in der Richtung A-A der Länge des Schlitzes reicht, und Figur 3c zeigt, daß in der Querrichtung B-B der Abstand groß gehalten ist.

Mit der in Figur 3a gezeigten Ausführung des wärmeleitenden Elements 3 mit einer Mehrzahl von Fingern oder Speichen kann auch deren Breite, Form und Verteilung zur Einstellung der Wärmeleitung herangezogen werden. Auch bei Ausführung als durchgehende Scheibe bzw. Lochblende kann die Dicke des wärmeleitenden Elements örtlich verschieden ausgeführt werden. Auch ist es möglich, die einzelnen Finger analog zu den Stegen 21-28 nach Figur 1 aus verschieden wärmeleitenden Materialien zu machen. Natürlich kann das wärmeleitende Element 3 auch beidseitig an der Linse 1 angeordnet werden.

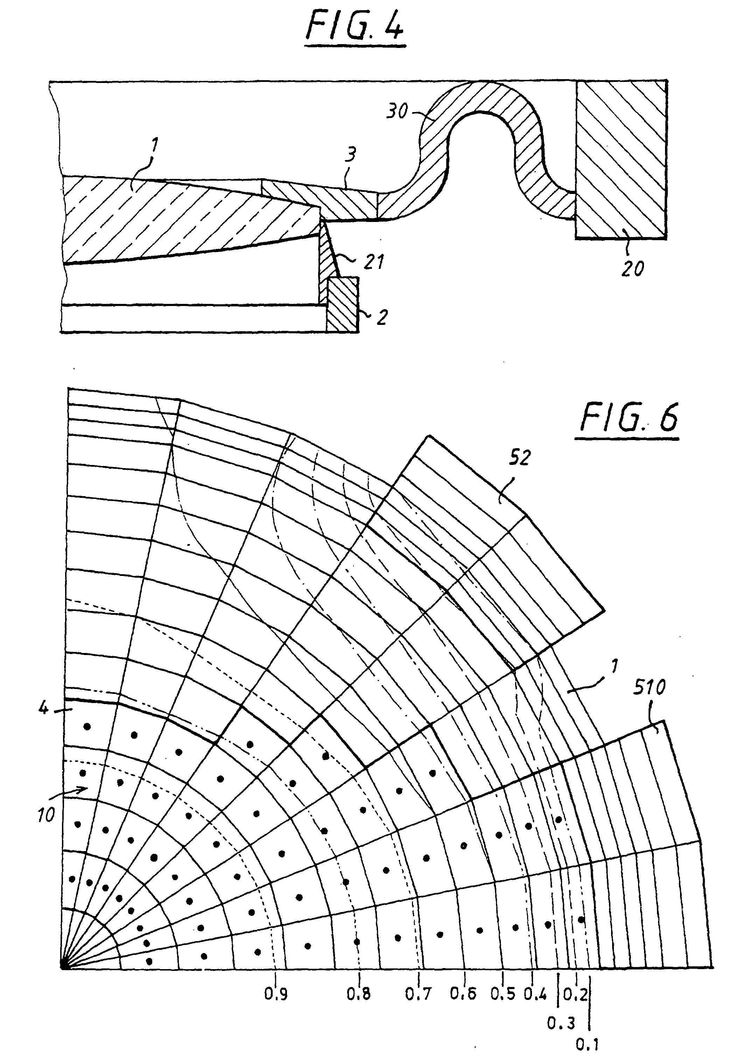

Fig. 4 zeigt in einer Fig. 3b entsprechenden Darstellung eine Möglichkeit, wie das Kühlelement 3 in stoff- oder formschlüssigen Kontakt zur Linse 1 gebracht werden kann, ohne daß die mechanischen Eigenschaften der Fassung 2 und der Verbindungsteile 21 gestört werden. Das Kühlelement 3 wird dazu mit einem flexiblen wärmeleitenden Kabel 30 ausgestattet - z.B. einer Kupferlitze - und an eine Wärmesenke 20 angeschlossen.

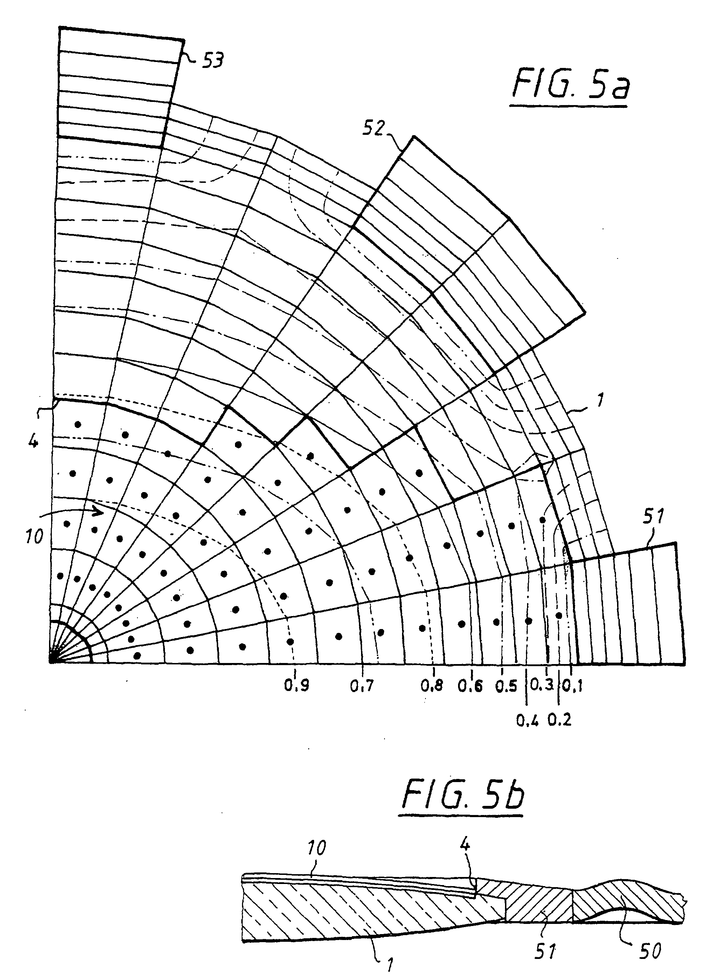

Figur 5a zeigt in Aufsicht das Finite-Elemente-Modell eines Quadranten einer Linse 1 aus Quarzglas (Mittendicke 14,4 mm, oberer Krümmungsradius 1600 mm, unterer Krümmungsradius 220 mm - bikonvex -, Durchmesser 160 mm). Acht massive Laschen (51, 52, 53) aus Aluminium sind gleichmäßig verteilt in der aus dem Schnitt Figur 5b erkennbaren Weise an der Linse 1 angeordnet. Sie sind 30 mm breit, über der Linse 2 mm dick und radial 6 mm überdeckend, außerhalb sind sie nochmals radial 8 mm lang in 4 mm Dicke. Am Außenrand sind sie auf Basistemperatur gehalten, z.B. durch flexible wärmeleitende Litzen 50.

Auf der gezeigten Oberfläche der Linse 1 wird in dem Bereich 4, der etwa ein Rechteck annähert in der gewählten Elementaufteilung, wird eine Wärmeeintragung durch Lichtabsorption von 1 W/cm² angesetzt. Die Temperaturerhöhung im Mittelpunkt erreicht dann 7,6 Milligrad. Eingezeichnet sind die Isothermen 0,1 bis 0,9, welche den Verlauf der Linien mit dem entsprechenden Bruchteil dieser Temperaturerhöhung anzeigen. Bei höherem Wärmeeintrag skaliert die Temperaturerhöhung in weiten Bereichen linear.

Ganz offensichtlich ist bei dieser dem Stand der Technik zuzurechnenden Ausführung mit symmetrischer Kühlanordnung die erreichte Temperaturverteilung stark unsymmetrisch über die ganze Linse verteilt.

Bei der erfindungsgemäßen Ausführung, die in Figur 6 dargestellt ist, sind die auf der Y-Achse liegenden Kühllaschen entfallen. Die auf der X-Achse liegenden Kühllaschen 510 sind in der Breite verdoppelt und zusätzlich aus dem besser wärmeleitenden Silber gefertigt. Die Laschen 52 dazwischen bleiben unverändert, ebenso wie die Wärmezufuhr im Bereich 4.

Damit wird nun die Temperaturerhöhung am Mittelpunkt 9,2 Milligrad. Die Isothermen sind bis etwa zum 0,7-fachen der maximalen Temperaturerhöhung und zum halben Linsendurchmesser jetzt gut rotationssymmetrisch.

Die mechanische Fassung der Linse 1 kann entweder durch die Kühllaschen 510, 52 erfolgen, oder es ist eine beliebige Fassungstechnik vorgesehen, die vorzugsweise vergleichsweise geringe Wärmeleitung aufweist.

Figur 7 zeigt eine Variante ähnlich Figur 3a-c, bei der die Finger 31, 32 des wärmeleitenden Elements aus Bimetall - zwei Lagen Material mit verschiedener Wärmeausdehnung - ausgeführt sind. Links im Bild ist bei der niedrigen Temperatur t₁ der Bimetallstreifen 31 von der Linse 1 weggebogen, er kann nur wenig Wärme aufnehmen. Rechts im Bild bei der höheren Temperatur t₂ ist der Bimetallstreifen 32 gestreckt und liegt in geringem Abstand zur Linse 1, so daß er viel Wärme abführen kann.

Außer bei den in den vorangegangenen Beispielen gezeigten Linsen kann die Erfindung natürlich auch bei prismatischen Teilen, bei Gittern oder Spiegeln angewendet werden, eben allen ungleichmäßig wärmebelasteten optischen Bauteilen.

Figur 8 zeigt eine speziell auf einen Spiegel 6 adaptierte Ausführung. Der Spiegel 6 ist auf einer Halterung 7 über auf seiner Rückseite verteilte Stützen 71 bis 77 - einzelne Stege oder Stützringe - abgestützt.

Über ihre Verteilung auf der Rückseite des Spiegels 6, ihre Form sowie über die spezifische Wärmeleitfähigkeit ihres Materials (z.B. in der Mitte 74 aus Silber, am Rand 72, 76 aus Blei, sonst (73, 75) Aluminium und der Außenrand 71, 77 aus Zerodur) wird die Kühlwirkung nach Bedarf eingestellt, in Anpassung an die ausgeleuchtete Fläche 10.

Die unterschiedliche Wärmeausdehnung der Materialien für die Stützen 71-77 kann ebenfalls gezielt ausgenutzt werden, um Deformationen des Spiegels 6 aufgrund der Erwärmung zu kompensieren, oder aber auch gezielt herbeizuführen. Im letzteren Fall können dann Störungen anderer optischer Elemente, die in einem System mit dem Spiegel 6 zusammenwirken, kompensiert werden.

Figur 9 zeigt das komplette optische System einer Projektionsbelichtungsanlage der Mikrolithographie im schematisierten Überblick. Ein DUV-Excimer-Laser dient als Lichtquelle 61. Eine strahlformende Optik 62 mit Zoom-Axicon-Objektiv 63, wahlweise einer Blende 64 (wechselbar, konventionelle, Ringapertur, Dipol-, Quadrupol-Apertur) und einem homogenisierenden Quarzstab 65 leuchtet die REMA-Blende 66 homogen aus, die durch das folgende REMA-Objektiv 67 als scharf berandeter homogener Leuchtfleck, insbesondere als schmaler Scan-Schlitz, auf die Maske 68 abgebildet wird.

Das folgende verkleinernde Projektionsobjektiv 69 bildet die Maske 68 auf dem Wafer 70 ab. Die feldnahen Linsen 671 und 672 des REMA-Objektivs 67 und 692 des Projektionsobjektivs 69 sind nun bevorzugte optische Elemente, an denen die erfindungsgemäße Kühlung eingesetzt wird. Diese Kühlung reduziert die bei einem Scanner, bei dem Maske 68 und Wafer 70 synchron gescannt werden, aufgrund des schmalen schlitzförmigen ausgeleuchteten Feldes entstehenden Abbildungsfehler.

Die Linse 691 ist nächst der Aperturblende 690 des Projektionsobjektivs 69 angeordnet. Sie wird durch besondere Beleuchtungsarten, z.B. Dipol-Apertur, besonders belastet (vgl. Figur 2). Durch die erfindungsgemäße asymmetrische Kühlung kann jedoch auch diese Störung reduziert werden.

Es ist klar, daß die Beschreibung der Figuren nur Beispiele für die in den Ansprüchen definierte Erfindung wiedergibt. Insbesondere sind vielfältige Kombinationen der beschriebenen Merkmale erfindungsgemäß möglich und die Kühlung kann auch verstellbar ausgeführt werden, um zu justieren, an Veränderungen anzupassen usw..

## Patentansprüche

1. Projektionsbelichtungsanlage der Mikrolithographie mit einer Lichtquelle und einem optischen Element (1), das durch Strahlung der Lichtquelle nicht rotationssymmetrisch beheizt wird, und einer nicht rotationssymmetrischen Kühlung (21-28, 211-214, 3) des optischen Elements (1), wobei die Kühlung durch passive wärmeleitende Einrichtungen (211-214, 3) bewirkt wird, **dadurch gekennzeichnet, dass** die passiven wärmeleitenden Einrichtungen (211-214, 3) aus Stegen mit unterschiedlichem Querschnitt oder aus Fingern unterschiedlicher Breite, Form oder Dicke bestehen, so dass eine zumindest teilweise Homogenisierung der Temperaturverteilung im optischen Element bewirkt wird.

2. Projektionsbelichtungsanlage der Mikrolithographie nach Anspruch 1 , wobei das optische Element (671, 672, 691; 1), in einer Fassung (2) befestigt ist, und das optische Element (671, 672, 691; 1) mit Strahlung derart beaufschlagt wird, dass eine Wärmezufuhr erfolgt, die keine der Form des optischen Elements (671, 672, 691; 1) entsprechende Symmetrie aufweist, und zwischen optischem Element (1) und Fassung (2) die genannte passive wärmeleitende Einrichtung als eine Verbindungsstruktur (21-28) vorgesehen ist, die eine nicht der Form des optischen Elements (1) entsprechende Symmetrie aufweist der art, dass die zumindest teilweise Homogenisierung der Temperaturverteilung im optischen Element (1) bewirkt wird.

3. Projektionsbelichtungsanlage der Mikrolithographie nach Anspruch 1, wobei das optische Element (1), das in einer Fassung (2) befestigt ist und das optische Element (1) mit Strahlung derart beaufschlagt wird, dass eine Wärmezufuhr erfolgt, die keine der Form des optischen Elements (1) entsprechende Symmetrie aufweist, und die genannte passive wärmeleitende Einrichtung als ein- oder mehrteiliges wärmeleitendes Element (21-28, 211-214, 3) ausgebildet ist und so in Wirkverbindung mit dem optischen Element (1) und der Fassung (2) angeordnet ist, dasseine Form des Wärmetransports entsteht, die eine zumindest teilweise Kompensation der Asymmetrie der Temperaturverteilung im optischen Element (1) bewirkt.

4. Projektionsbelichtungsanlage der Mikrolithographie nach Anspruch 1 weiter, **dadurch gekennzeichnet, dass** mindestens ein Teil (3) in thermischem Kontakt zum optischen Element (1) steht, einen Teil des nicht von der Strahlung berührten Querschnitts des optischen Elements (1) abdeckt, und Temperaturgradienten im optischen Element (1) reduziert.

5. Projektionsbelichtungsanlage nach mindestens einem der Ansprüche 1-4 weiter, **dadurch gekennzeichnet, dass** das optische Element (1) ein transmittierendes Element, insbesondere eine Linse (1) ist.

6. Projektionsbelichtungsanlage nach mindestens einem der Ansprüche 1-4 weiter, **dadurch gekennzeichnet, dass** das optische Element ein Spiegel (6) ist.

7. Projektionsbelichtungsanlage nach mindestens einem der Ansprüche 1-6 weiter, **dadurch gekennzeichnet, dass** das Bildfeld (10) schlitzförmig ist.

8. Projektionsbelichtungsanlage nach mindestens einem der Ansprüche 5-7 weiter, **dadurch gekennzeichnet, dass** das optische Element (671, 672, 692) nahe einer Feldebene angeordnet ist.

9. Projektionsbelichtungsanlage nach mindestens einem der Ansprüche 1-6 weiter, **dadurch gekennzeichnet, dass** die Beleuchtung des Retikels nicht rotationssymmetrisch ist, insbesondere vom Typ der schiefen, der Dipol-, oder Quadrupol-Beleuchtung ist.

10. Projektionsbelichtungsanlage nach Anspruch 9 weiter, **dadurch gekennzeichnet, dass** das optische Element (691) nahe einer Pupillenebene (690) angeordnet ist.

11. Projektionsbelichtungsanlage nach Anspruch 2 weiter, **dadurch gekennzeichnet, dass** die Verbindungsstruktur (21-28, 211-214) aus Teilen aufgebaut ist, die aus verschiedenen Materialien bestehen.

12. Projektionsbelichtungsanlage nach Anspruch 3 weiter, **dadurch gekennzeichnet, dass** das wärmeleitende Element aus Teilen aus verschiedenem Material zusammengesetzt ist.

13. Projektionsbelichtungsanlage nach Anspruch 1 weiter, **dadurch gekennzeichnet, dass** die wärmeleitenden Einrichtungen aus Teilen aus verschiedenem Material bestehen.

14. Projektionsbelichtungsanlage nach Anspruch 4 weiter, **dadurch gekennzeichnet, dass** das oder die in thermischem Kontakt stehenden Teile (3, 31, 32) aus mehreren verschiedenen Materialien bestehen.

15. Projektionsbelichtungsanlage nach Anspruch 2 weiter, **dadurch gekennzeichnet, dass** die Verbindungsstruktur (211-214) verstellbare Teile (221-224) aufweist.

16. Projektionsbelichtungsanlage nach Anspruch 3 weiter, **dadurch gekennzeichnet, dass** das wärmeleitende Element (31, 32) verstellbar ist.

17. Projektionsbelichtungsanlage nach Anspruch 1 weiter, **dadurch gekennzeichnet, dass** die wärmeleitenden Einrichtungen verstellbare Teile aufweisen.

18. Projektionsbelichtungsanlage nach Anspruch 4 weiter, **dadurch gekennzeichnet, dass** das oder die in thermischem Kontakt stehenden Teile (31, 32) zumindest teilweise verstellbar sind.

## Claims

1. Microlithography projection exposure system having a light source and an optical element (1) which is heated by radiation from the light source in a non-rotationally symmetrical fashion, and having non-rotationally symmetrical cooling (21-28, 211-214, 3) of the optical element (1), the cooling being effected by passive heat-conducting devices (211-214, 3), **characterized in that** the passive heat-conducting devices (211-214, 3) comprise webs of different cross section, or fingers of different width, shape or thickness, such that an at least partial homogenization of the temperature distribution in the optical element is effected.

2. Microlithography projection exposure system according to Claim 1, in which the optical element (671, 672, 691; 1) is fastened in a mount (2) and radiation is applied to the optical element (671, 672, 691; 1) in such a way that heat is fed in a fashion exhibiting no symmetry corresponding to the shape of the optical element (671, 672, 691; 1), and the said passive heat-conducting device is provided between optical element (1) and mount (2) as a connecting structure (21-28) which exhibits a symmetry not corresponding to the shape of the optical element (1) in such a way that the at least partial homogenization of the temperature distribution in the optical element (1) is effected.

3. Microlithography projection exposure system according to Claim 1, in which the optical element (1) is fastened in a mount (2) and radiation is applied to the optical element (1) in such a way that heat is fed in a fashion exhibiting no symmetry corresponding to the shape of the optical element (1) and the said passive heat-conducting device is designed as a unipartite or multipartite heat-conducting element (21-28, 211-214, 3) and is arranged to be operationally connected to the optical element (1) and the mount (2) such that a form of heat transport results which effects an at least partial compensation of the asymmetry of the temperature distribution in the optical element (1).

4. Microlithography projection exposure system according to Claim 1, further **characterized in that** at least one part (3) is in thermal contact with the optical element (1), covers a part of the cross section of the optical element (1) not touched by the radiation, and reduces temperature gradients in the optical element (1).

5. Projection exposure system according to at least one of Claims 1-4, further **characterized in that** the optical element (1) is a transmitting element, in particular a lens (1).

6. Projection exposure system according to at least one of Claims 1-4, further **characterized in that** the optical element is a mirror (6).

7. Projection exposure system according to at least one of Claims 1-6, further **characterized in that** the image field (10) is slit-shaped.

8. Projection exposure system according to at least one of Claims 5-7, further **characterized in that** the optical element (671, 672, 692) is arranged near a field plane.

9. Projection exposure system according to at least one of Claims 1-6, further **characterized in that** the illumination of the reticle is non-rotationally symmetrical, in particular of the type of oblique, dipole or quadrupole illumination.

10. Projection exposure system according to Claim 9, further **characterized in that** the optical element (691) is arranged near a pupil plane (690).

11. Projection exposure system according to Claim 2, further **characterized in that** the connecting structure (21-28, 211-214) is constructed from parts which consist of different materials.

12. Projection exposure system according to Claim 3, further **characterized in that** the heat-conducting element is assembled from parts made from different material.

13. Projection exposure system according to Claim 1, further **characterized in that** the heat-conducting devices consist of parts made from different material.

14. Projection exposure system according to Claim 4, further **characterized in that** the part or parts (3, 31, 32) in thermal contact consist of a number of different materials.

15. Projection exposure system according to Claim 2, further **characterized in that** the connecting structure (211-214) has adjustable parts (221-224).

16. Projection exposure system according to Claim 3, further **characterized in that** the heat-conducting element (31, 32) is adjustable.

17. Projection exposure system according to Claim 1, further **characterized in that** the heat-conducting devices have adjustable parts.

18. Projection exposure system according to Claim 4, further **characterized in that** the part or parts (31, 32) in thermal contact are at least partially adjustable.

## Revendications

1. Système d'éclairage par projection en microlithographie, qui présente une source de lumière et un élément optique (1) qui est chauffé sans symétrie de rotation par le rayonnement de la source de lumière ainsi qu'un refroidissement (21 à 28, 211 à 214, 3) sans symétrie de rotation de l'élément optique (1), le refroidissement étant réalisé par des dispositifs thermiquement conducteurs passifs (211 à 214, 3), **caractérisé en ce que** les dispositifs thermiquement conducteurs passifs (211 à 214, 3) sont constitués d'ailettes de différentes sections transversales ou de doigts de différentes largeurs, formes ou épaisseurs de manière à réaliser une homogénéisation au moins partielle de la répartition des températures dans l'élément optique.

2. Système d'éclairage par projection en microlithographie selon la revendication 1, dans lequel l'élément optique (671, 672, 691; 1) est fixé dans une monture (2), dans lequel l'élément optique (671, 672, 691; 1) est irradié de telle sorte qu'il reçoive un apport de chaleur qui ne présente pas une symétrie qui correspond à la forme de l'élément optique (671, 672, 691; 1) et dans lequel ledit dispositif thermiquement conducteur passif qui présente la forme d'une structure de liaison (21 à 28) est prévu entre l'élément optique (1) et la monture (2) et a une symétrie qui ne correspond pas à la forme de l'élément optique (1), de manière à réaliser l'homogénéisation au moins partielle de la répartition des températures dans l'élément optique (1).

3. Système d'éclairage par projection en microlithographie selon la revendication 1, dans lequel l'élément optique (1) est fixé dans une monture (2) et l'élément optique (1) est irradié de manière à réaliser un apport de chaleur qui ne présente pas une symétrie qui correspond à la forme de l'élément optique (1), ledit dispositif thermiquement conducteur passif étant configuré comme élément thermiquement conducteur (21 à 28, 211 à 214, 3) en une pièce ou en plusieurs pièces et étant disposé de manière à coopérer avec l'élément optique (1) et la monture (2) de manière à obtenir un transport de chaleur dont la forme a pour effet une compensation au moins partielle de l'asymétrie de la répartition des températures dans l'élément optique (1).

4. Système d'éclairage par projection en microlithographie selon la revendication 1, **caractérisé en outre en ce qu'**au moins une partie (3) est en contact thermique avec l'élément optique (1), couvre une partie de la section transversale de l'élément optique (1) qui n'est pas touchée par le rayonnement et qui réduit les gradients de température dans l'élément optique (1).

5. Système d'éclairage par projection en microlithographie selon au moins l'une des revendications 1 à 4, **caractérisé en outre en ce que** l'élément optique (1) est un élément de transmission et en particulier une lentille (1).

6. Système d'éclairage par projection en microlithographie selon au moins l'une des revendications 1 à 4, **caractérisé en outre en ce que** l'élément optique (1) est un miroir (6).

7. Système d'éclairage par projection en microlithographie selon au moins l'une des revendications 1 à 6, **caractérisé en outre en ce que** le champ d'image (10) a la forme d'une fente.

8. Système d'éclairage par projection en microlithographie selon au moins l'une des revendications 5 à 7, **caractérisé en outre en ce que** l'élément optique (671, 672, 692) est disposé à proximité d'un plan de champ.

9. Système d'éclairage par projection en microlithographie selon au moins l'une des revendications 1 à 6, **caractérisé en outre en ce que** le réticule n'est pas éclairé à symétrie de rotation mais est éclairé obliquement, en dipôle ou en quadripôle.

10. Système d'éclairage par projection en microlithographie selon la revendication 9, **caractérisé en outre en ce que** l'élément optique (691) est disposé à proximité d'un plan de pupille (690).

11. Système d'éclairage par projection en microlithographie selon la revendication 2, **caractérisé en outre en ce que** la structure de liaison (21 à 28, 211 à 214) est constituée de pièces formées de matériaux différents.

12. Système d'éclairage par projection en microlithographie selon la revendication 3, **caractérisé en outre en ce que** l'élément thermiquement conducteur est constitué de l'assemblage de matériaux différents.

13. Système d'éclairage par projection en microlithographie selon la revendication 1, **caractérisé en outre en ce que** les dispositifs thermiquement conducteurs sont constitués pièces en matériaux différents.

14. Système d'éclairage par projection en microlithographie selon la revendication 4, **caractérisé en outre en ce que** les pièces (3, 31, 32) en contact thermique sont constituées en plusieurs matériaux différents.

15. Système d'éclairage par projection en microlithographie selon la revendication 2, **caractérisé en outre en ce que** la structure de liaison (211 à 214) présente des pièces ajustables (221 à 224).

16. Système d'éclairage par projection en microlithographie selon la revendication 3, **caractérisé en outre en ce que** l'élément thermiquement conducteur (31, 32) est ajustable.

17. Système d'éclairage par projection en microlithographie selon la revendication 1, **caractérisé en outre en ce que** les dispositifs thermiquement conducteurs présentent des pièces ajustables.

18. Système d'éclairage par projection en microlithographie selon la revendication 4, **caractérisé en outre en ce que** la ou les pièces en contact thermique (31, 32) sont ajustables au moins en partie.
